Europäisches Patentamt

European Patent Office

Office européen des brevets

(11) Veröffentlichungsnummer: **0 665 456 A1**

# (12) EUROPÄISCHE PATENTANMELDUNG

(21) Anmeldenummer: **94116384.2**

(22) Anmeldetag: **18.10.94**

(51) Int. Cl.6: **G02B 6/42**, H01L 31/0352

(30) Priorität: **27.01.94 DE 4402288**

(43) Veröffentlichungstag der Anmeldung:
**02.08.95 Patentblatt 95/31**

(84) Benannte Vertragsstaaten:
**ES FR GB IT NL**

(71) Anmelder: **ANT Nachrichtentechnik GmbH**
**Gerberstrasse 33**
**D-71522 Backnang (DE)**

(72) Erfinder: **Kuke, Albrecht, Dr.**
**Nelkenweg 2**
**D-71545 Auenwald (DE)**

(54) **Optoelektrischer Wandler.**

(57) Die Erfindung betrifft einen optoelektrischen Wandler mit einer lichtempfindlichen Fläche, die nicht kreisrund sondern elliptisch ist, wodurch eine besonders gute Anpassung erreicht wird für die Einkopplung von Licht, das auf der lichtempfindlichen Fläche einen elliptischen Fleck erzeugt.

EP 0 665 456 A1

Die Erfindung betrifft einen optoelektrischen Wandler mit einer lichtempfindlichen Fläche.

Beim Auftreffen von Licht auf einen optoelektrischen Wandler ist der Lichtfleck auf der lichtempfindlichen Fläche des Wandlers oftmals nicht rund. Da die lichtempfindlichen Flächen kreisförmig ausgebildet sind, muß der Durchmesser der lichtempfindlichen Fläche mindestens so groß gewählt sein, daß der Lichtfleck ganz auf diese Fläche paßt, um Koppelverluste gering zu halten. Es ist auch möglich mit Linsensystemen den Lichtfleck an die lichtempfindliche Fläche des optoelektrischen Wandlers anzupassen.

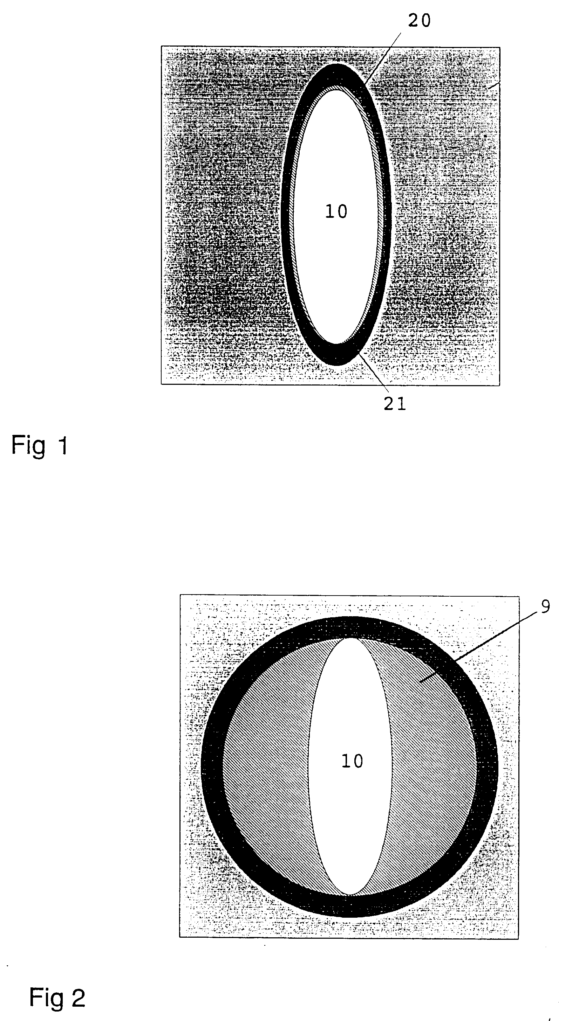

Einen elliptischen Lichtfleck erhält man beispielsweise auf einer Fotodiode bei allen Ankopplungsarten, bei denen der aus dem Lichtwellenleiter austretende Strahl bereits ein elliptisches Profil besitzt. Dies ist, durch die Technologie bedingt, bei den meisten Streifenwellenleitern der Fall. Bisher werden Fotodioden mit einer kreisförmigen aktiven Fläche eingesetzt. Um die Koppelverluste möglichst klein zu halten, muß der Durchmesser der kreisförmigen aktiven Flächen herkömmlicher Art mindestens so groß sein wie der große Durchmesser des elliptischen Lichtfleckes auf der Fotodiode (s. Figur 2: Lichtfleck 10, aktive Fläche 9). Die für eine Fotodiode erreichbare Grenzfrequenz ist aber um so geringer, je größer die aktive Fläche der Fotodiode ist. Zur Erzielung einer hohen Grenzfrequenz ist daher eine möglichst kleine aktive Fläche erforderlich.

Es ist Aufgabe der Erfindung einen optoelektrischen Wandler anzugeben, der bei der Einkopplung von Licht mit elliptischem Lichtfleck auf der lichtempfindlichen Fläche geringe Koppelverluste aufweist.

Die Aufgabe wird durch einen optoelektrischen Wandler mit den Merkmalen des Patentanspruches 1 gelöst. Im Unteranspruch 2 ist eine Ausgestaltung einer Fotodiode vorgeschlagen, bei welcher die aktive Fläche nicht kreisförmig sondern elliptisch ist, wobei die Größe und Form der Ellipse dem Anwendungsfall angepaßt ist.

Eine solche Fotodiode ist in Figur 1 dargestellt. Durch die kleine elliptische aktive Fläche 20, die dem Lichtfleck 10 angepaßt ist, kann die Kapazität der Fotodiode klein gehalten werden. Die Kontaktierung der oberen lichtdurchlässigen Elektrode erfolgt durch einen metallisierten Rand 21, der sich um die aktive Fläche herum befindet. Bei einer Ellipse sind die Abstände der Flächenelemente zum Rand geringer als bei einem Kreis. Dadurch wird der elektrische Widerstand der Fotodiode geringer als bei einer herkömmlichen Fotodiode mit kreisförmiger aktiver Fläche. Beide Größen, geringe Kapazität und geringer Widerstand bewirken eine Erhöhung der Grenzfrequenz.

**Patentansprüche**

1. Optoelektrischer Wandler mit einer lichtempfindlichen Fläche, dadurch gekennzeichnet, daß die lichtempfindliche Fläche (9) elliptisch ist und für das Verhältnis der Halbachsen a und b gilt:

   $a : b \geq 1,2$

2. Optoelektrischer Wandler nach Anspruch 1, dadurch gekennzeichnet, daß die lichtempfindliche Fläche die aktive Fläche einer Fotodiode ist.

Fig 1

Fig 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PATENT ABSTRACTS OF JAPAN vol. 12 no. 414 (E-677) ,2.November 1988 & JP-A-63 151232 (CANON INC) 23.Juni 1988, * Zusammenfassung * | 1,2 | G02B6/42 H01L31/0352 |
| | --- | | |
| X | PATENT ABSTRACTS OF JAPAN vol. 10 no. 52 (P-432) [2109] ,28.Februar 1986 & JP-A-60 196709 (NIPPON DENKI K.K.) 5.Oktober 1985, * Zusammenfassung * | 1,2 | |
| | ----- | | |

**RECHERCHIERTE SACHGEBIETE (Int.Cl.6)**

G02B
H01L

Der vorliegende Recherchenbericht wurde für alle Patentansprüche erstellt

| Recherchenort | Abschlußdatum der Recherche | Prüfer |
|---|---|---|
| DEN HAAG | 12.April 1995 | Lut, K |